# EUROPEAN PATENT SPECIFICATION

(11) **EP 0 315 483 B1**
(45) Date of publication and mention of the grant of the patent: **16.02.1994**
(21) Application number: 88310421.8
(22) Date of filing: 04.11.1988
(51) Int. Cl.: H01L 27/10, H01L 21/82

(54) **Semiconductor memory**
Halbleiterspeicher
Mémoire semi-conductrice

(30) Priority: 06.11.1987 JP 281382/87
(43) Date of publication of application: 10.05.1989
(73) Proprietor: SHARP KABUSHIKI KAISHA, Osaka 545 (JP)
(72) Inventor: Iguchi, Katsuji, Yamatokoriyama-shi Nara-ken (JP); Urai, Masahiko, Nara-shi Nara-ken (JP); Masuichi, Chiyako, Kitamidorigaoka Toyonaka-shi Osaka (JP)
(74) Representative: Brown, Kenneth Richard

(56) References cited:
- EP-A- 0 220 392
- EP-A- 0 236 089
- EP-A- 0 237 361

## Description

The present invention relates to semiconductor memories, and more particularly to semiconductor memories of a DYNAMIC RANDOM ACCESS MEMORY (hereinafter abbreviated to as DRAM) type which consist of storage capacity cells.

The bit capacity of DRAMs at the forefront of the race towards higher integration has shown a four-fold growth in the last three years. At present, mainly 256 Kb (Kilobits) DRAMs and 1 Mb (Megabits) DRAMs are being produced, with 4 Mb DRAMs being under development. It is expected that still larger capacity DRAMs, such as 16 Mb and 64 Mb DRAMs, will progressively be developed in the near future. In the DRAMs currently being produced, one bit is stored in a memory cell comprising a single transistor (pass transistor) and a single capacitor. A single cell of the 4 Mb DRAMs currently under development has an area of the order of about 10 µm². With the increasing storage capacity, the cell area will be gradually diminished to 5 µm² (16 Mb) and then 2.5 µm² (64 Mb). In order to prevent radiation induced soft errors, however, 200 fc (femtocoulomb) or more charge must be stored in the capacitor of each cell, and the capacitance of each cell must be maintained at an order of 40 fF (femto-farad).

It is not feasible to maintain such as above capacitance on the silicon wafer surface alone in the case of 4 Mb DRAMs. Therefore, the capacitor is formed in trenches each having a depth of 2 µm - 8 µm formed in the silicon wafer surface. A variety of DRAM cell structures have been proposed utilizing such trenches.

Generally, when designing DRAM memory cells, as great a capacitance as possible should be maintained on the available surface region without impairing the pass transistor in each cell and the cell-to-cell insulation characteristics. Theoretically possible methods for increasing the capacitance is to make the dielectric between electrodes thinner, or to employ materials which have a higher dielectric constant than those currently used, thereby increasing the capacitance per unit area. At present, however, the dielectric materials suitable for practical use are limited to a SiO₂ film or SiO₂/Si₃N₄ composite film only, and a maximum capacitor equivalent to 100 Å thick SiO₂ film is all that can be reliably achieved. Accordingly, the capacitance of a capacitor (condenser) per unit area is about of 3.5 fF/µm², and hence a capacitor with an electrode area of approximately 11.4 µm² is required to maintain a capacitance of 40 fF.

Various cell structures have been proposed to form a capacitor with an electrode area larger than 10 µm² in a cell having a surface area of only approximately 10 µm².

More specifically, there has been proposed a cell structure which is called trench transistor cell (TTC) comprising a capacitor formed in the lower portion of a trench and a vertical pass transistor formed in the upper portion of the trench (see IEEE IEDM: International Electron Devices Meeting, Transactions, p.714, Dec. 1985). This cell structure has the following merits; it can dispense with the area necessary for the pass transistor and bit line contact holes, is less affected by the short channel effect or narrow channel effect of the pass transistor, there is no risk of punching through between the trenches, and is highly tolerant against α-particle induced soft errors. However, the proposed cell structure has the following drawbacks; it requires the use of an expensive P/P⁺ epitaxial wafer and also the formation of very deep trenches in that wafer, resulting in very complicated manufacturing steps. Further, it cannot adopt the (1/2) Vcc arrangement which is effective in improving the reliability of an insulating film in the capacitor.

There has also been proposed a cell structure which is called BSE (Buried/Storage Electrode Cell) (See IEEE IEDM, Transactions, p.710, Dec. 1985). In this cell structure, a capacitor and a pass transistor are formed in the coplanar surface. Since BSE employs a P/P⁺ epitaxial substrate as with above TTC, BSE has the merits of no interaction between the capacitors, and a high tolerance against α-ray, etc., while it has the demerits of increased cost, and no compatibility with the (1/2) Vcc arrangement, etc. In addition, the BSE manufacturing steps are more simple than those of the TTC. However, since the area available for the capacitor is very small, it is expected that BSE will not be adapted for higher integration densities such as 16 Mb and 64 Mb.

Thus, because of using a P/P⁺ epitaxial substrate and utilizing a P⁺ portion of the substrate as a plate electrode of the capacitor, TTC and BSE have the merits of no appreciable interaction between the capacitors, and high tolerance against α-ray, etc., while they have the demerits of increased cost, and no compatibility with the (1/2) Vcc arrangement, etc. Furthermore, these types of cells have disadvantages when it is attempted to increase the capacitance in the trench, because the capacitor trench is located at the center of each cell and an isolation region surrounds the outer side of the capacitor trench, thereby resulting in a structure in which the circumference of the capacitor trench is shorter than that of the cell. Due to the manufacturing process, the trench must have its side walls inclined to some degree, and by necessity therefore the trench becomes V-shaped. With this structure, therefore, the side area of the trench will not be increased even if a deeper trench is formed, and the capacitance cannot be made larger in proportion to the depth of the trench.

For this reason, it is necessary to make the circumference of the trench as long as possible, in order to form a capacitor with the largest practicable capacitance in a limited area. To this end, it is advantageous to form a trench around the cell, and have the cell isolation region and the capacitor region formed inside the trench.

One of these types of cells, a FCC (Folded Capacitor Cell) has been proposed (see IEEE IEDM, Transactions, p.244, Dec. 1984). With this cell structure, although the circumference of the capacitor portion is nearly comparable with that of BSE, the trench is V-shaped and this has the merit that the side area of the trench is increased with larger depth. However, problems still exist in the various manufacturing processes such as the cell-to-cell isolating method at the trench bottom, impurity implanting method to the trench side wall, etc. and also the fact that there is a lower tolerance against α-ray than in the BSE type of cell.

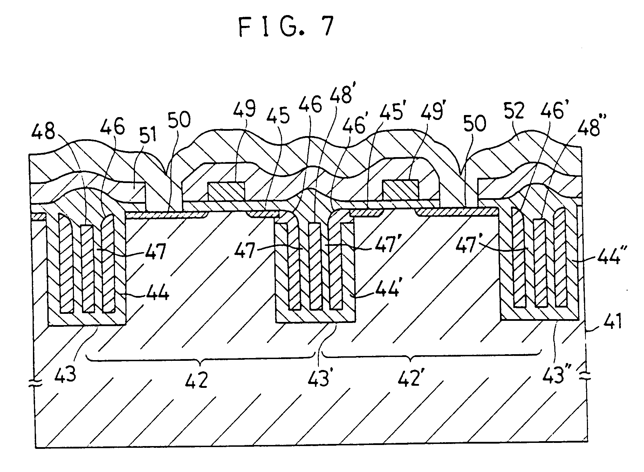

There has also been proposed a cell structure, as shown in Fig. 7, which is called IVEC (Isolation Merged Vertical Capacitor Cell) (see IEEE IEDM, Transactions, p.240, Dec. 1984). In Fig. 7, trenches 43, 43', 43'' are formed to surround memory cell regions 42 and 42' of a silicon substrate 41, and capacitor electrodes 46 and 46' connected to drain regions 45 and 45' of pass transistors via insulating films (SiO₂ films) 44, 44' and 44'' are formed in the trenches 43, 43' and 43''. The capacitor electrodes (doped polycrystalline silicon) 46, 46' are also contiguous with the plate electrodes (doped polycrystalline silicon) 48, 48' and 48'' via capacitor insulating films (SiO₂ films) 47 and 47'. Designated at 49 and 49' are word lines serving as gate electrodes for the pass transistors, 50 and 50' are source regions of the pass transistors, 51 is an interlayer insulating film, and 52 is a bit line connected to the source regions 50 and 50'.

This IVEC cell is very effective in increasing the capacitor's capacitance, because the capacitor is disposed around the cell and has a large circumference. Also, capacitor separation by the insulating films results in less interference between the cells. Further, since the capacitor electrodes are isolated from the silicon substrate by the insulating films, tolerance against α-rays is high. However, with the capacitor electrodes disposed on the side faces of the pass transistors via the insulating films, there is a possibility that a conducting channel may be developed in the side faces of the pass transistors and eventually the pass transistors may leak when the capacitor electrodes are at a relatively higher potential and the bit line is at a relatively lower potential. Although the IVEC cell has excellent characteristics as mentioned above, its structure faces inherent problems of leakage of the pass transistors in the course of future development to the higher integration densities such as 16 Mb and 64 Mb.

Another example of memory cells utilising trench capacitors is disclosed in European Patent Application EP-A-0 236 089. In this example, an annular trench is disposed in a semiconductor substrate to one side of its associated pass transistor. A capacitor is formed in the trench by forming an insulating layer on the inner side wall surfaces of the trench, and forming a first conductive layer on the insulating layer and bottom surface of the trench. A dielectric layer is then formed over the first conductive layer, and a second conductive layer is then formed on the dielectric layer and fills the trench. The first conductive layer, dielectric layer and the second conductive layer form the capacitor. A MIS transistor formed in the semiconductor substrate has its source or drain region connected to the second conductive layer, thereby forming a memory cell utilising a trench capacitor.

It is an aim of the present invention to provide a semiconductor memory, such as a DRAM whose individual memory cells comprise a single capacitor and a single transistor, which can prevent leakage of the transistor even with larger memory capacity.

According to the present invention, a semiconductor memory is provided wherein a plurality of memory cells each comprising a single capacitor and a single transistor to store one bit are formed on a semiconductor substrate, each transistor having a gate electrode and first and second source/drain terminals, each first source/drain terminal of the respective transistors of said memory cells being connected to a common wiring portion, the capacitor of each memory cell being disposed in a trench having a groove-like shape, said trench being formed in said semiconductor substrate along the outer periphery of one or two adjacent said transistors, said capacitors comprising a first insulating film covering an inner sidewall surface of said trench, a first electrode formed over a surface of said first insulating film and supplied with a predetermined voltage, a second insulating film disposed all over the surface of said first electrode, and a second electrode disposed on said second insulating film in an area corresponding to an inner sidewall surface of said trench and connected to the second source/drain terminal of the respective transistors.

A semiconductor memory according to the present invention can overcome the above-mentioned shortcomings in the prior art. More specifically, since the capacitor is formed in a trench around a memory cell region on the semiconductor substrate, the first electrode is disposed via a first insulating film on the peripheral side face of the transistor formed in the memory cell region, and the second electrode is disposed to cover the first electrode via the second insulating film, it is possible to reliably prevent a conducting channel from being produced on the transistor's peripheral side face and thereby prevent leakage of the transistor, even when the second electrode is at higher potential than the first electrode. Since the capacitor can have a longer circumference, it is also possible to increase its capacitance even with a smaller area of the memory cell. Furthermore, since all adjacent capacitors are isolated by the first insulating film, interference between the memory cells can be prevented. In addition, high tolerance is expected against α-ray induced soft errors.

Specific embodiments of the invention will now be described by way of example and with reference to the accompanying drawings, in which:
Fig. 1 illustrates the sequential nature of the process used to manufacture the memory cell showing a first embodiment of the present invention;
Fig. 2 is an explanatory view of an essential portion of the first embodiment;
Fig. 3 illustrates the sequential nature of the process used to manufacture the memory cell showing a second embodiment of the present invention;
Fig. 4 is a sectional view taken along the line A-A in Fig. 3(c);
Fig. 5 is a sectional view taken along the line B-B in Fig. 3(e);
Fig. 6(a) and 6(b) are equivalent circuit diagrams of the first and second embodiments of the present invention, respectively; and
Fig. 7 is an explanatory view for the construction of a memory cell showing an example of the prior art.

A semiconductor substrate employed in the present invention is formed from a material such as silicon, gallium-arsenic or indium-phosphor, preferably p-type or n-type.

A trench in the present invention has an opening in the range 1.5 - 0.4 µm, and preferably in the range 1.0 - 0.5 µm. The trench depth is preferably in the range of 1 - 6 µm with the aspect ratio preferably not larger than 5. The trench is convergent in configuration and has an inclination angle in range with respect to the substrate surface of 1° - 5°, preferably 3°.

Further, the trench has a circumference in the range of 2 - 10 µm, or preferably in the range of 2 - 5 µm.

First and second insulating films employed in the present embodiment are formed from a material such as SiO₂, Si₃N₄ or Ta₂O₅ (or a combination thereof). The first insulating film has a thickness in the range of 500 - 1500 Å, preferably 1000 Å, while the second insulating film has a thickness in the range of 50 - 200 Å, or preferably 100 Å (1Å = 0.1 mm).

First and second electrodes employed in the present invention are formed of a thin film of phosphor doped polycrystalline silicon, arsenic doped polycrystalline silicon, or the like.

In particular, the second electrode has a film thickness preferably in the range of 0.05 - 0.2 µm.

A common wiring portion employed in the present invention is formed from a material such as an aluminum-silicon-copper alloy or tungsten silicide. The connection between the second electrode and the terminals of a transistor is made using the same material as the common wiring portion.

Hereinafter, an embodiment of the present invention will be described with reference to the drawings. It should be noted that the scope of the present invention is not restricted by the following embodiment.

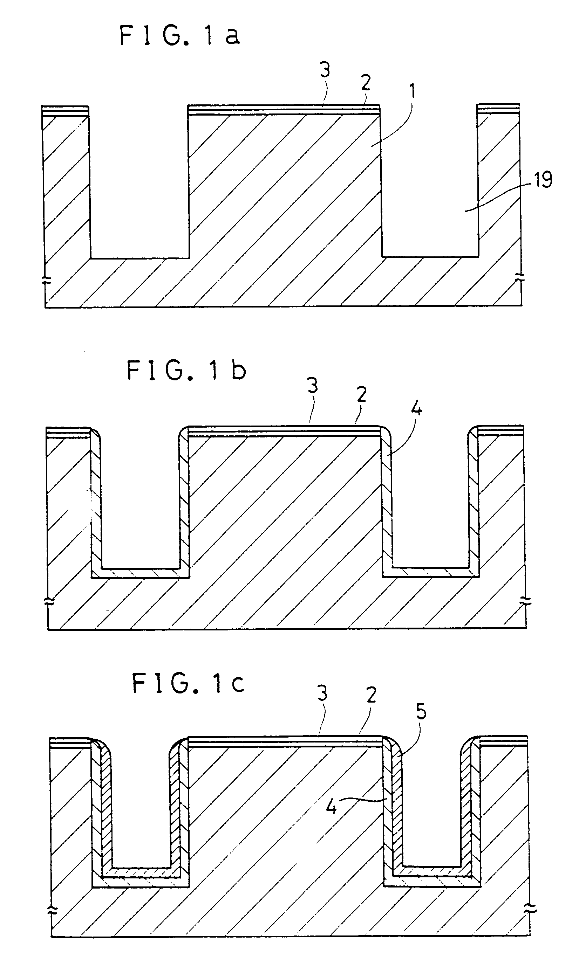

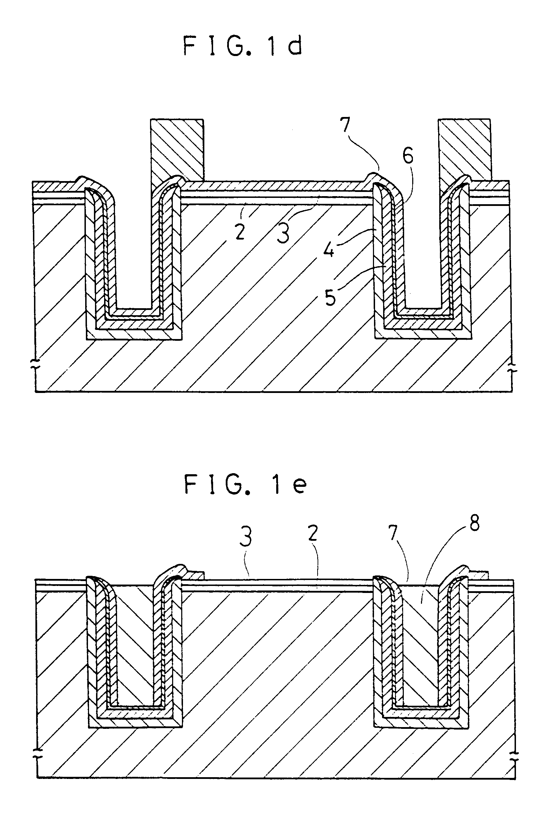

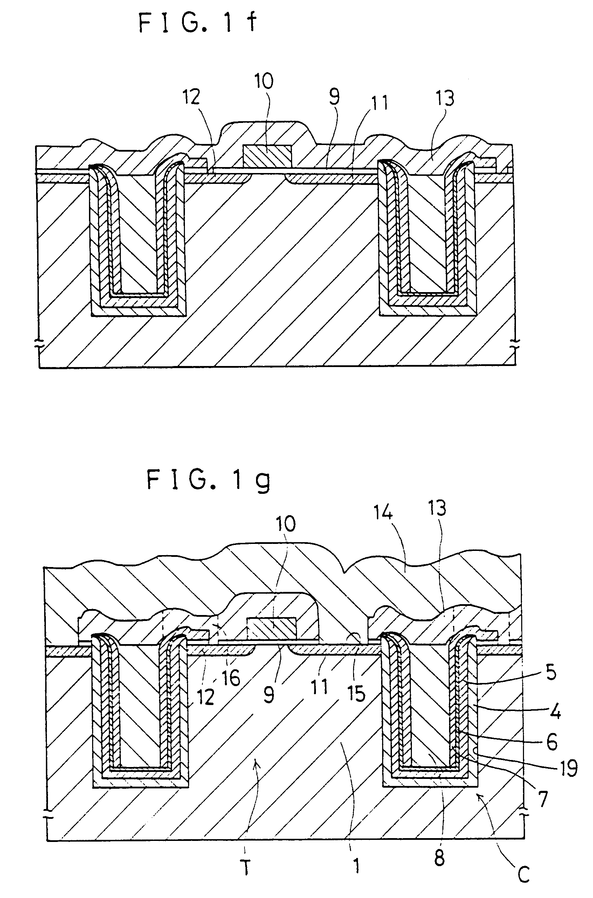

Fig. 1 shows a first embodiment of the present invention applied to a memory cell for 16 Mb DRAM.

In Figs. l(g) and 2, the memory cell comprises a single capacitor C and a single n-channel MOS transistor (pass transistor) T, and stores one bit.

The transistor T is disposed on a p-type silicon substrate 1 via a gate oxide film 9 formed of SiO₂, and consists of a gate electrode 10, serving as a word line, which is formed of a two-layered film comprising phosphor doped polycrystalline silicon and tungsten silicide, a source (source region) 11 formed of an arsenic diffused layer, and a drain (drain region) 12 also formed of an arsenic diffused layer.

The capacitor C is formed in a trench 19 dug in the form of groove around the memory cell region. The transistor T has its sidewall covered with a SiO₂ film (first insulating film) 4 with a film thickness of 0.1 µm which in turn is covered by a capacitor plate electrode (hereinafter referred to simply as a plate electrode) 5. Formed of a phosphor doped polycrystalline silicon thin film and which serves as a first electrode. More specifically, the trench 19 has a V-shape with an inclination angle of 3°, upon which the SiO₂ film 4 is formed over the inner wall surface of the trench. The plate electrode 5 is then formed on the SiO₂ film 4. On the inner side of the plate electrode 5, there is formed a SiO₂ film 6 (second insulating film) with a film thickness of 0.015 µm, upon which a capacitor electrode 7, serving as a second electrode, and formed of a thin film of phosphor doped polycrystalline silicon is formed. The capacitor electrode 7 has a thickness of 0.1 µm and hence can maintain higher tolerance against α-induced soft errors.

The source 11 of the transistor T is conducted to a plurality of memory cells via the common wiring portion 14 serving as a bit line. Reference 15 indicates a contact hole used for such conduction. The bit line 14 is formed of an aluminum-silicon-copper alloy.

The capacitor electrode 7 is connected to the drain 12 of the transistor T via a contact hole 16 using an aluminum-silicon-copper alloy.

The plate electrodes 5 of the many memory cells are commonly connected via a common wiring portion (not shown) which serves as a fixed potential supply line, and is supplied with constant voltage outside the memory cell regions.

At this time, the applied voltage may be set equal to one half the supply voltage Vcc so that the plate electrode 5 is subjected to a voltage of (1/2) Vcc, or set equal to 0 V or below. In any case, the optimum value can be selected to optimize the device characteristics. As an alternative, after forming the first insulating film 4, it is possible to etch away the bottom of the film 4 for connecting the first electrode 5 to the substrate 1, so that the first electrode 5 is held at the same potential (e.g., 0 V) as the substrate 1.

The method of manufacturing will be described below. First, after oxidizing the surface of the p-type silicon substrate 1 under heating and forming a SiO₂ thin film 2, a Si₃N₄ thin film 3 is deposited thereon by the LP (low-pressure) CVD method, and a resist pattern is then formed by the photolithography method. Both the thin films 2 and 3 are etched away by employing the resist as a mask. Subsequently, trench etching of the substrate 1 is carried out to form the trench 19. After peeling off the resist and cleaning the substrate, boron is diffused into all the inner wall surfaces of the trench 19 [see Fig. l(a)]. Then, after depositing a SiO₂ film over the substrate surface by the LPCVD method, the SiO₂ film on the substrate surface is removed by the etch-back method. More specifically, after painting a resist on the SiO₂ film and applying RIE-etching to the whole resist surface, the SiO₂ film as an underlying film for the resist is etched away so that the resist is only left in the trench 19. As a result, only the SiO₂ film on the top surface of the substrate 1 is removed and not that in the trench 19. In this way, a SiO₂ film 4 is only left over the inner wall surface of the trench 19 [see Fig. l(b)]. Then, a phosphor doped polycrystalline silicon thin film is deposited over the substrate surface, and the deposited silicon thin film on the top surface of the substrate is removed by the etch-back method, so that a phosphor doped polycrystalline silicon layer 5 is only left on the SiO₂ film 4 [see Fig. l(c)] . Subsequently, the polycrystalline silicon film 5 is thermally oxidized to form a SiO₂ film 6 for the capacitor, followed by forming a phosphor doped polycrystalline silicon thin film 7 [see Fig. l(d)] .

Next, the polycrystalline silicon thin film 7 on the surface is etched away by the RIE-etching method except for the polycrystalline silicon thin film 7 on the side wall surface of the trench and on the small top surface region. Then, after depositing a SiO₂ film 8 by the LPCVD method in the trench, the SiO₂ film on the top surface of the substrate is removed by the etch-back method [see Fig. l(e)]. After peeling off the Si₃N₄ film 3 and the SiO₂ film 2 on the substrate surface, a gate oxide film 9 formed of SiO₂ is formed by the thermal oxidization method. A two-layered film comprising phosphor doped polycrystalline silicon and tungsten silicide is deposited on the gate oxide film 9 and then etched to form the gate electrode 10. Subsequently, after implanting arsenic ions, the substrate is subjected to heat treatment to form n⁺ diffusion layers 11, 12 which serve as source and drain regions of the n-channel MOS transistor, respectively. Thereafter, a BPSG (boron-phosphor-silicaglass) film 13 serving as an interlayer insulating film is deposited [see Fig. l(f)].

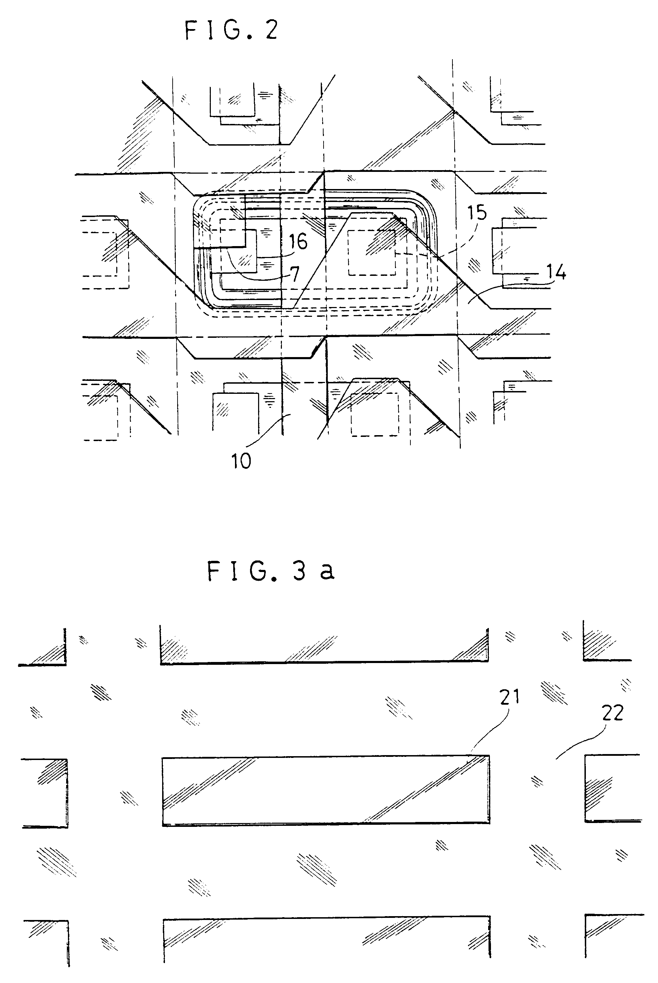

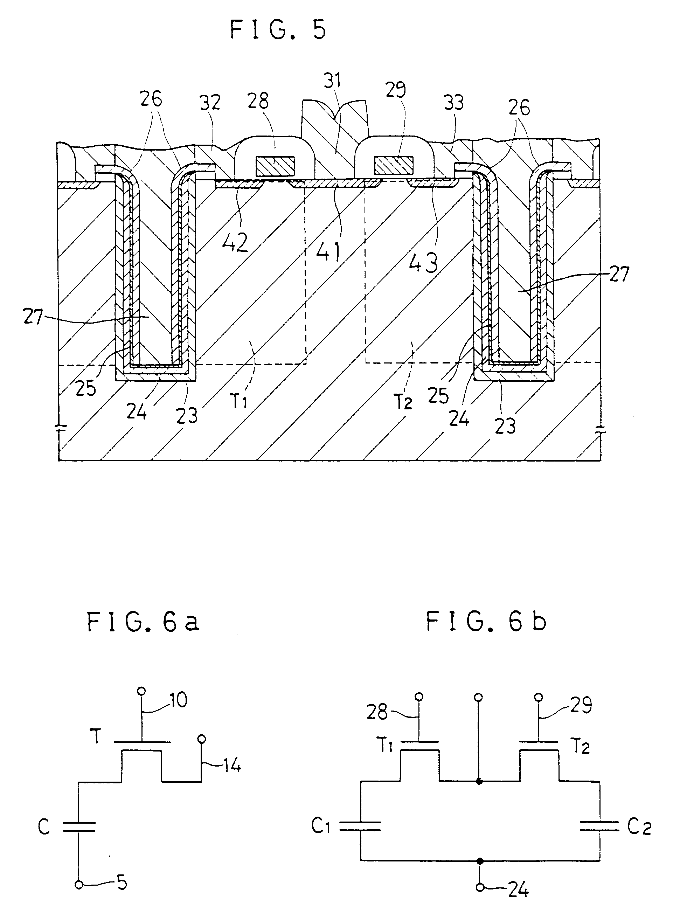

Next, the contact hole 15 for connecting the bit line 14 and the source 11 of the pass transistor T, as well as the contact hole 16 for connecting the phosphor doped polycrystalline silicon 7 serving as the capacitor electrode and the drain 12 of the pass transistor T are bored [see Fig. 2], and an aluminum-silicon-copper alloy is deposited in a predetermined pattern [see Fig. l(g)]. At this time, as shown in Fig. 2, the bit line pattern covers the contact hole 15, but leaves the contact hole 16 exposed. Specifically, during etching the aluminum-silicon-copper alloy the contact hole 16 is separated from the bit line 14 and its lower portion is filled with that alloy. Fig. 6(a) shows an equivalent circuit of the resulting memory cell.

The memory cell formed through the foregoing process has an area of 1.75 µm x 3 µm = 5.25 µm² per cell and the minimum size of the pattern used to an order of 0.5 µm.

The trench 19 formed in this embodiment has a width of 1.0 µm at the opening edge, a depth of 3 µm, and a sidewall inclination angle of 3°. Although it is difficult to measure a film thickness of the capacitor insulating film 6, that film thickness is estimated at approximately 150 Å based on a capacitance evaluation of a planar type capacitor which has been formed under the same conditions.

The memory cell of this embodiment has a capacitance of 45 fF. Thus, it is possible to realize a very large capacitance even with a relatively shallow trench having an aspect ratio of 3. Further, the hold time of carriers stored in the memory cell is comparable to that of the conventional planar type capacitor, and therefore the memory cell of this embodiment is suitable for practical use.

Also, there are no problems regarding punch through or leakage between the capacitors.

In short, according to the memory cell of this embodiment, within the trench which surrounds the memory cell region, there is disposed the plate electrode 5 on the trench inner wall surface via the SiO₂ film 4 and the capacitor electrode 7 on the inner side via the capacitor insulating film 6. Therefore, the side face of the pass transistor is always covered by the plate electrode 5 via the SiO₂ film 4. The plate electrode 5 is held not greater than (1/2) Vcc, and formation of a side face channel is restrained and hence the margin in cell design becomes very wide. In other words, 16 Mb DRAM can be formed with an area of the memory cell not larger than 5.25 µm² and with an aspect ratio of the trench not larger than 5. In addition, by reducing the minimum size of the pattern used to an order of 0.25 µm, the memory cell can be fabricated with an area not larger than 2.5 µm² and applied to 64 Mb DRAM as well. Further, it is expected that this memory cell is less affected by interference and leakage between the cells, and is also highly resistant against α-ray induced soft errors. Accordingly, this memory cell has high practical value and will be suited to the future development of DRAMs with higher integration densities.

Next, a second embodiment of the present invention applied to a memory cell for 16 Mb DRAM, will be described.

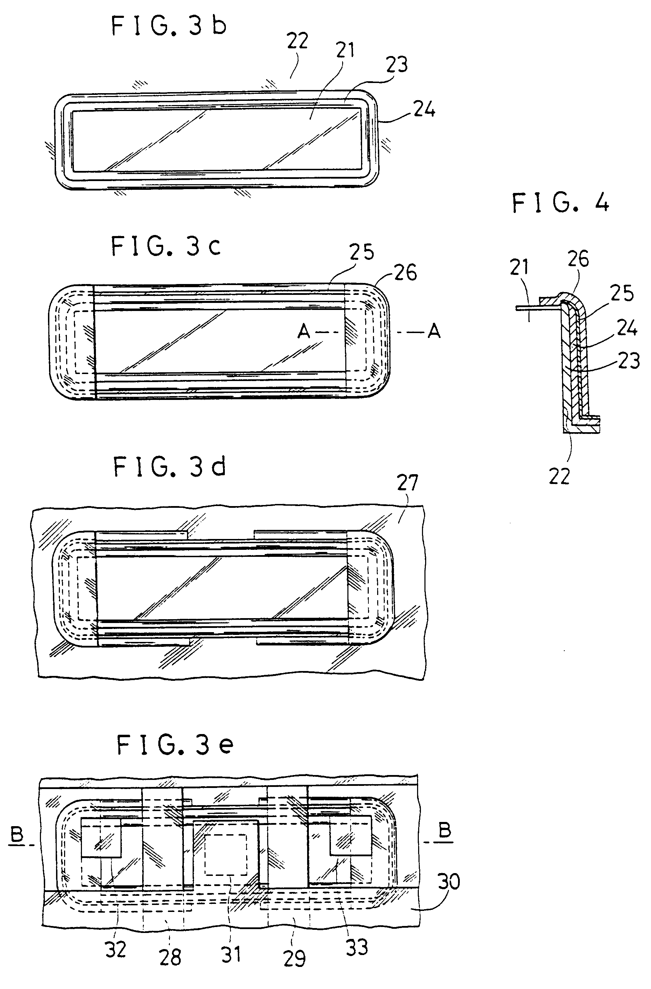

Fig. 3 shows the sequential nature of the manufacturing process of the memory cell of this embodiment. In the foregoing, the first embodiment individual memory cells are separated by the trenches and a set of adjacent memory cells shares a bit line contact. Note that Fig. 3 illustrates the manufacturing steps.

First, in Fig. 3, after oxidizing the surface of a p-type silicon substrate 21 and depositing a Si₃N₄ film, the silicon substrate 21 is etched by employing a resist as a mask to form a trench 22 with a width of 1 µm. Then, boron is diffused into all the inner wall surfaces of the trench 22 [see Fig. 3(a)]. Subsequently, after depositing a SiO₂ film, the SiO₂ film on the top surface is removed by the etch-back method. Then, a phosphor doped polycrystalline silicon thin film is deposited all over the substrate surface, and the deposited silicon thin film on top surface of the substrate is removed by the etch-back method, so that a phosphor doped polycrystalline silicon layer 24 serving as a plate electrode is left over only the inner wall surface of the trench. Accordingly, a SiO₂ film 23 serving as a first insulating film and the polycrystalline silicon layer 24 are formed over only the trench inner wall [see Fig. 3(b)]. Then, the polycrystalline silicon layer 24 is thermally oxidized to form a capacitor insulating film 25 formed of SiO₂, and this is followed by the deposition of a phosphor doped polycrystalline silicon layer 26 which serves as a capacitor electrode. The polycrystalline silicon layer is etched away by the RIE-etching method while only leaving the polycrystalline silicon layer on a portion of the cell surface [see Fig. 3(c)]. Fig. 4 shows a section taken along the line A-A in Fig.3(c). After etching the polycrystalline silicon layer 26 on a portion of the trench sidewall through the resist process and depositing a SiO₂ film, etch-back is carried out to build a SiO₂ 27 in the trench [see Fig. 3(d)]. After peeling off the SiO₂ film on the substrate surface, a gate oxide film is formed by thermal oxidization. A two-layered film comprising phosphor doped polycrystalline silicon and tungsten silicide is deposited on the gate oxide film and then etched to form the gate electrodes 28 and 29 which serve as word lines. Subsequently, after implanting arsenic ions, the substrate is subjected to heat treatment to form the source region 41 and drain regions 42, 43 of the n-channel MOS transistor. Thereafter, a BPSG film serving as an interlayer insulating film is deposited and subjected to heat treatment. Then, a contact hole 31 for connecting a bit line 30 formed of an aluminum-silicon-copper alloy and a common source 41 of two pass transistors T1 and T2, as well as contact holes 32 and 33 for connecting the capacitor electrode 26 and drains 42 and 43 of the pass transistors, are bored. Subsequently, an aluminum-silicon-copper alloy is deposited in a predetermined pattern to form the bit line 30. At this time, as with the above first embodiment, the contact holes 32 and 33 are not included in the bit line pattern, but separated from the bit line [see Fig. l(g)]. Fig. 5 shows a section of this memory cell. An equivalent circuit of the memory cell is shown in Fig. 6(b). In Fig. 6(b), C1 and C2 indicate capacitors.

The memory cell formed through the foregoing process has an area of 1.75 µm x 2.25 µm = 3.94 µm² per cell and the minimum size of 0.5 µm. The trench has a width of 1.0 µm at the opening edge and a depth of 5 µm. Other process conditions are similar to those in the above first embodiment, and the memory cell of this embodiment has a capacitance of 40 fF. This memory cell is also excellent with respect to the other characteristics described for the first embodiment. Furthermore, this embodiment enables the formation of a 16 Mb DRAM in a smaller chip than the case formed by the first embodiment.

As fully described above, according to the present invention, a capacitor is formed in a trench defined around a memory cell region on a semiconductor substrate, a first electrode is disposed via a first insulating film on the peripheral side face of a transistor formed in the memory cell region, and a second electrode is disposed to cover the first electrode via a second insulating film. Therefore, even when the second electrode is at a higher potential than the first electrode, it is possible to prevent a channel from being produced on the transistor's peripheral side face, and hence prevent leakage of the transistor. Since the capacitor can have a longer circumference, it is also possible to increase its capacitance even with a smaller area of the memory cell. Further, since all adjacent capacitors are isolated by the insulating film, interference between the memory cells can be prevented. Another advantageous characteristic is that high tolerance is expected against α-ray induced soft errors, because the particular electrodes are formed of thin films. Consequently, the present memory cell has a very high practical value in terms of the future development of DRAMs with higher integration densities.

The skilled man will appreciate that the above described embodiments may be modified in various ways within the scope of the following claims.

## Claims

1. A semiconductor memory wherein a plurality of memory cells each comprising a single capacitor (C; C1, C2) and a single transistor (T; T1, T2) to store one bit are formed on a semiconductor substrate (1; 21), each transistor (T; T1, T2) having a gate electrode (10; 28, 29) and first and second source/drain terminals (11, 12; 41, 42, 43), each first source/drain terminal (11; 41) of the respective transistors (T; T1, T2) of said memory cells being connected to a common wiring portion (14; 30), the capacitor of each memory cell being disposed in a trench (19; 22) having a groove-like shape, said trench (19; 22) being formed in said semiconductor substrate (1; 21) along the outer periphery of one or two adjacent said transistors (T; T1, T2), said capacitors (C; C1, C2) comprising a first insulating film (4; 23) covering an inner sidewall surface of said trench (19; 22), a first electrode (5; 24) formed over a surface of said first insulating film (4; 23) and supplied with a predetermined voltage, a second insulating film (6; 25) disposed all over the surface of said first electrode (5; 24), and a second electrode (7; 26) disposed on said second insulating film (6; 25) in an area corresponding to said inner sidewall surface of said trench (19; 22) and connected to the second source/drain terminal (12; 42, 43) of the respective transistors (T; T1, T2).

2. A semiconductor memory according to claim 1, wherein said first electrode (5; 24) is disposed on said first insulating film (4; 23) along a whole inner surface of said trench (19; 22).

3. A semiconductor memory according to claim 1, wherein said first electrode (5; 24) is disposed on an inner sidewall surface of said first insulating film (4; 23) which corresponds to the inner sidewall surface of said trench (19; 22).

4. A semiconductor memory according to any preceding claim, wherein said trench (19) is formed along the outer periphery of said one transistor (T).

5. A semiconductor memory according to any of claims 1 to 3, wherein said trench is formed along the outer periphery of two adjacent transistors (T₁, T₂), said two adjacent transistors (T₁, T₂) sharing one first source/drain terminal (41) which is commonly connected to said common wiring portion (30).

6. A semiconductor memory according to any preceding claim, wherein said trench (19; 22) has an opening width of 0.4 - 1.5 µm, a depth of 1 - 6 µm, and a ratio of depth to opening width (aspect ratio) of 5 or less.

7. A semiconductor memory according to any preceding claim, wherein said trench (19; 22) has a circumferential length of 2 - 10 µm.

8. A semiconductor memory according to any preceding claim, wherein said trench (19; 22) has a convergent or V-shaped configuration such that its greatest width is its opening width.

9. A semiconductor memory according to claim 8, wherein the inner sidewall surface of said trench (19; 22) has an inclination angle of 1 - 5° with respect to a plane normal to the opening surface.

10. A semiconductor memory according to any preceding claim, wherein said semiconductor substrate (1; 21) is formed of a Si material.

11. A semiconductor memory according to claim 10, wherein said first (4; 23) and second (6; 25) insulating films are formed of a material such as SiO₂, Si₃N₄ or Ta₂O₅, or a combination thereof.

12. A semiconductor memory according to any of claims 1 to 9, wherein said semiconductor substrate (1; 21) is formed of a material such as GaAs or InP.

13. A semiconductor memory according to claim 11, wherein said first insulating film (4; 23) has a film thickness of 50 - 150 nm (500 - 1500 Å).

14. A semiconductor memory according to claim 11 or claim 13, wherein said second insulating film (6; 25) has a film thickness of 5-20 nm (50 - 200 Å).

15. A semiconductor memory according to claim 1, wherein said common wiring portion (14; 30) is formed of an Al·Si·Cu alloy or tungsten silicide.

16. A semiconductor memory according to claim 10, wherein said first (5; 24) and second (7; 26) electrodes are formed of phosphor doped polycrystalline silicon.

## Patentansprüche

1. Halbleiterspeicher, bei dem mehrere Speicherzellen mit jeweils einem einzigen Kondensator (C; C1, C2) und einem einzigen Transistor (T; T1, T2) zum Speichern eines Bits auf einem Halbleitersubstrat (1; 21) ausgebildet sind, wobei jeder Transistor (T; T1, T2) eine Gateelektrode (10; 28, 29) und einen ersten und einen zweiten Source/Drain-Anschluß (11, 12; 41, 42, 43) aufweist, wobei jeder erste Source/Drain-Anschluß (11; 41) des jeweiligen Transistors (T; T1, T2) der Speicherzellen mit einem gemeinsamen Leiterabschnitt (14; 30) verbunden ist, der Kondensator jeder Speicherzelle in einem Graben (19; 22) mit Nutform angeordnet ist, der Graben (19; 22) im Halbleitersubstrat (1; 21) entlang des Außenumfangs eines oder zweier benachbarter Transistoren (T; T1, T2) angeordnet ist, und die Kondensatoren (C; C1, C2) folgendes aufweisen: einen ersten Isolierfilm (4; 23), der die erste Innenseitenwandfläche des Grabens (19; 22) abdeckt, eine erste Elektrode (5, 24), die auf einer Fläche des ersten Isolierfilms (4; 23) ausgebildet ist und mit einer vorgegebenen Spannung versorgt wird, einen zweiten Isolierfilm (6; 23), der über der gesamten Fläche der ersten Elektrode (5; 24) ausgebildet ist, und eine zweite Elektrode (7; 26), die auf dem zweiten Isolierfilm (6; 25) in einem Bereich ausgebildet ist, der der Innenseitenwandfläche des Grabens (19; 22) entspricht und mit dem zweiten Source/Drain-Anschluß (12; 42, 43) des jeweiligen Transistors (T; T1, T2) verbunden ist.

2. Halbleiterspeicher nach Anspruch 1, bei dem die erste Elektrode (5; 25) auf dem ersten Isolierfilm (4; 23) entlang einer Innenwandfläche des Grabens (19; 22) angebracht ist.

3. Halbleiterspeicher nach Anspruch 1, bei dem die erste Elektrode (5; 24) auf einer Innenseitenwandfläche des ersten Isolierfilms (4; 23), die der Innenseitenwandfläche des Grabens (19; 22) entspricht, angebracht ist.

4. Halbleiterspeicher nach einem der vorstehenden Ansprüche, bei dem der Graben (19) entlang dem Außenumfang des einen Transistors (T) ausgebildet ist.

5. Halbleiterspeicher nach einem der Ansprüche 1 bis 3, bei dem der Graben entlang dem Außenumfang zweier benachbarter Transistoren (T1, T2) ausgebildet ist, wobei die zwei benachbarten Transistoren (T1, T2) einen ersten Source/Drain-Anschluß (41) gemeinsam nutzen, der gemeinsam an den gemeinsamen Leiterabschnitt (30) angeschlossen ist.

6. Halbleiterspeicher nach einem der vorstehenden Ansprüche, bei dem der Graben (19; 22) eine Öffnungsweite von 0,4 - 1,5 µm, eine Tiefe von 1 - 6 µm und ein Verhältnis der Tiefe zur Öffnungsbreite (Seitenverhältnis) von 5 oder weniger aufweist.

7. Halbleiterspeicher nach einem der vorstehenden Ansprüche, bei dem der Graben (19; 22) eine Umfangslänge von 2 - 10 µm aufweist.

8. Halbleiterspeicher nach einem der vorstehenden Ansprüche, bei dem der Graben (19; 22) eine konvergierende oder V-förmige Konfiguration in solcher Weise aufweist, daß seine größte Breite die Öffnungsbreite ist.

9. Halbleiterspeicher nach Anspruch 8, bei dem die Innenseitenwandfläche des Grabens (19; 22) einen Neigungswinkel von 1 - 5 ° gegen eine Ebene normal zur Öffnungsfläche aufweist.

10. Halbleiterspeicher nach einem der vorstehenden Ansprüche, bei dem das Halbleitersubstrat (1; 21) aus einem Si-Material besteht.

11. Halbleiterspeicher nach Anspruch 10, bei dem der erste Isolierfilm (4; 23) und der zweite Isolierfilm (6; 25) aus einem Material wie SiO₂, Si₃N₄ oder Ta₂O₅ oder einer Kombination hieraus bestehen.

12. Halbleiterspeicher nach einem der Ansprüche 1 bis 9, bei dem das Halbleitersubstrat (1; 21) aus einem Material wie GaAs oder InP besteht.

13. Halbleiterspeicher nach Anspruch 11, bei dem der erste Isolierfilm (4; 23) eine Filmdicke von 50 - 150 nm (500 - 1.500 Å) aufweist.

14. Halbleiterspeicher nach Anspruch 11 oder Anspruch 13, bei dem der zweite Isolierfilm (6; 25) eine Filmdicke von 5 - 20 nm (50 - 200 Å) aufweist.

15. Halbleiterspeicher nach Anspruch 1, bei dem der gemeinsame Leiterabschnitt (14; 30) aus einer Al·Si·Cu-Legierung oder aus Wolframsilizid besteht.

16. Halbleiterspeicher nach Anspruch 10, bei dem die erste Elektrode (5; 24) und die zweite Elektrode (7; 26) aus phosphordotiertem polykristallinem Silizium bestehen.

## Revendications

1. Mémoire à semi-conducteurs dans laquelle une multiplicité de cellules de mémoire, comprenant chacune un condensateur unique (C; C1, C2) et un transistor unique (T; T1, T2) pour emmagasiner un bit, sont formées sur un substrat semi-conducteur (1; 21), chaque transistor (T; T1, T2) ayant une électrode de grille (10; 28, 29) et des première et seconde bornes de source/drain (11, 12; 41, 42, 43), chaque première borne de source/drain (11; 41) des transistors respectifs (T; T1, T2) desdites cellules de mémoire étant reliée à une partie de câblage commune (14; 30), le condensateur de chaque cellule de mémoire étant disposé dans une tranchée (19; 22) ayant la forme d'une rainure, ladite tranchée (19; 22) étant formée dans ledit substrat à semi-conducteur (1; 21) le long de la périphérie externe de l'un desdits transistors ou de deux desdits transistors adjacents (T; T1, T2), lesdits condensateurs (C; C1, C2) comprenant un premier film isolant (4; 23) couvrant une surface de paroi latérale interne de ladite tranchée (19; 22), une première électrode (5; 24) formée sur une surface dudit premier film isolant (4; 23) et recevant une tension prédéterminée, un second film isolant (6; 25) disposé sur toute la surface de ladite première électrode (5; 24), et une seconde électrode (7; 26) disposée sur ledit second film isolant (6; 25) dans une zone correspondant à ladite surface de paroi latérale interne de ladite tranchée (19; 22) et reliée à la seconde borne de source/drain (12; 42, 43) des transistors respectifs (T; T1, T2).

2. Mémoire à semi-conducteurs selon la revendication 1, dans laquelle ladite première électrode (5; 24) est disposée sur ledit premier film isolant (4; 23), le long de la totalité d'une surface interne de ladite tranchée (19; 22).

3. Mémoire à semi-conducteurs selon la revendication 1, dans laquelle ladite première électrode (5; 24) est disposée sur une surface de paroi latérale interne dudit premier film isolant (4; 23) qui correspond à la surface de paroi latérale interne de ladite tranchée (19; 22).

4. Mémoire à semi-conducteurs selon l'une quelconque des revendications précédentes, dans laquelle ladite tranchée (19) est formée le long de la périphérie externe dudit transistor (T).

5. Mémoire à semi-conducteurs selon l'une quelconque des revendications 1 à 3, dans laquelle ladite tranchée est formée le long de la périphérie externe de deux transistors adjacents (T₁, T₂), lesdits deux transistors adjacents (T₁, T₂) partageant une première borne de source/drain (41) qui est reliée en commun à ladite partie de câblage commune (30).

6. Mémoire à semi-conducteurs selon l'une quelconque des revendications précédentes, dans laquelle ladite tranchée (19; 22) a une largeur d'ouverture comprise entre 0,4 et 1,5 µm, une profondeur comprise entre 1 et 6 µm, et un rapport de la profondeur à la largeur d'ouverture (rapport géométrique) égal à 5 ou moins.

7. Mémoire à semi-conducteurs selon l'une quelconque des revendications précédentes, dans laquelle ladite tranchée (19; 22) a une longueur circonférentielle comprise entre 2 et 10 µm.

8. Mémoire à semi-conducteurs selon l'une quelconque des revendications précédentes, dans laquelle ladite tranchée (19; 22) a une configuration convergente, ou en forme de V, telle que sa plus grande largeur est sa largeur d'ouverture.

9. Mémoire à semi-conducteurs selon la revendication 8, dans laquelle la surface de paroi latérale interne de ladite tranchée (19; 22) a un angle d'inclinaison compris entre 1 et 5° par rapport à un plan normal à la surface d'ouverture.

10. Mémoire à semi-conducteurs selon l'une quelconque des revendications précédentes, dans laquelle ledit substrat semi-conducteur (1; 21) est réalisé en Si.

11. Mémoire à semi-conducteurs selon la revendication 10, dans laquelle lesdits premier (4; 23) et second (6; 25) films isolants sont réalisés en une matière telle que SiO₂, Si₃N₄ ou Ta₂O₅, ou en une combinaison de ces matières.

12. Mémoire à semi-conducteurs selon l'une quelconque des revendications 1 à 9, dans laquelle ledit substrat semi-conducteur (1; 21) est réalisé en une matière telle que GaAs ou InP.

13. Mémoire à semi-conducteurs selon la revendication 11, dans laquelle l'épaisseur de film dudit premier film isolant (4; 23) est comprise entre 50 et 150 nm (500 et 1500 Å).

14. Mémoire à semi-conducteurs selon la revendication 11 ou la revendication 13, dans laquelle l'épaisseur de film dudit selon film isolant (6; 25) est comprise entre 5 et 20 nm (50 et 200 Å).

15. Mémoire à semi-conducteurs selon la revendication 1, dans laquelle ladite partie de câblage commune (14; 30) est réalisée en un alliage de Al, Si, Cu ou en siliciure de tungstène.

16. Mémoire à semi-conducteurs selon la revendication 10, dans laquelle lesdites première (5; 24) et seconde (7; 26) électrodes sont réalisées en silicium polycristallin dopé avec du phosphore.
